(19) Europäisches Patentamt
European Patent Office
Office européen des brevets

(11) **EP 3 105 614 B1**

(12) **EUROPEAN PATENT SPECIFICATION**

(45) Date of publication and mention
of the grant of the patent:
**31.01.2018 Bulletin 2018/05**

(21) Application number: **14833297.6**

(22) Date of filing: **19.12.2014**

(51) Int Cl.:
**E03B 3/34** *(2006.01)*      **G01S 13/95** *(2006.01)*

(86) International application number:
**PCT/SK2014/000024**

(87) International publication number:
**WO 2015/094130 (25.06.2015 Gazette 2015/25)**

(54) **METHOD AND APPARATUS FOR LIGHTNING THREAT INDICATION**

VERFAHREN UND VORRICHTUNG ZUR BLITZGEFÄHRDUNGSANZEIGE

PROCÉDÉ ET APPAREIL D'INDICATION DE MENACE D'ÉCLAIR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.12.2013 SK 1142013**

(43) Date of publication of application:
**21.12.2016 Bulletin 2016/51**

(73) Proprietors:
• **Ustav Stavebnictva A Architektury Sav
84503 Bratislava 45 (SK)**
• **Univerzita Komenskeho V Bratislave
818 06 Bratislava (SK)**
• **Videen, Gorden
Adelphi, Maryland 20905 (US)**

(72) Inventors:
• **VIDEEN, Gorden
Adelphi, Maryland 20905 (US)**
• **KOCIFAJ, Miroslav
841 07 Bratislava (SK)**
• **KLACKA, Jozef
841 05 Bratislava (SK)**

(74) Representative: **DREISS Patentanwälte PartG
mbB
Friedrichstrasse 6
70174 Stuttgart (DE)**

(56) References cited:
**US-A- 5 621 410**

• **KLACKA ET AL: "Scattering of electromagnetic
waves by charged spheres and some physical
consequences", JOURNAL OF QUANTITATIVE
SPECTROSCOPY AND RADIATIVE TRANSFER,
ELSEVIER SCIENCE, OXFORD, GB, vol. 106, no.
1-3, 29 April 2007 (2007-04-29), pages 170-183,
XP022071938, ISSN: 0022-4073, DOI:
10.1016/J.JQSRT.2007.01.016**

## Description

### Field of the invention

The technical solution concerns the field of applied meteorology, mainly the use of information about the state of electric charge of water droplets to indicate the lightning threat for various applications.

### Description of the related art

Currently, methods for analyzing the electric potential can be used to forecast the chance of electromagnetic (EM) discharge during storms. These methods most commonly use technologies based on the evaluation of radar and thermal data. One of the methods using the radar system operates, for example, on the principle of coherent and incoherent correlation of parallel and cross-polarized radar echo signals. The electric charge causes a distortion of the droplet shape, and the received signal depends on the shape of droplets. This method is ambiguous as droplet shape also can change due to other factors such as wind shear. The degree of non-sphericity of droplets can be estimated on the basis of the analysis of the correlation coefficient, and consequently the potential occurrence of lightning can be indicated.
Other patents related to lightning detection are as follows:

> U.S. Patent 4,792,806 , Lightning position and tracking method
> U.S. Patent 5,140,523 , Neural network for predicting lightning
> U.S. Patent 5,621,410 , Remote prediction of lightning hazards
> U.S. Patent 6,405,134 , Method and apparatus for predicting lightning threats based on radar and temperature data
> U.S. Patent 6,586,920 , Lightning detector
> U.S. Patent 6,828,911 , Lightning detection and prediction alarm device
> U.S. Patent 7,069,258 , Weather prediction method for forecasting selected events
> U.S. Patent 4,792,806, Lightning position and tracking method

Other solutions focused on lightning threat indication are as follows:

> US2011090111 A1 **20110421**
> The solution operates on the basis of recognition and classification of forms of hydrometeors from polarimetric radar measurements: signals with different polarization are used.

> JPH09329672 A **19971222**
> The solution according to this patent uses vertically and horizontally polarized waves, and on the basis of their change in the received radar echo, the shape of the particles is considered and subsequently, to the probability of storms.

> EP0186402 A2 **19860702**
> This solution uses an antenna for the detection of the E- and H- components of the electric and magnetic field. The extent of storm activity is evaluated as a function of the magnetic field measured in two frequencies.

The drawbacks of the prior art solutions are that they are highly dependent on external factors, such as wind shear, that affects the morphology of particles, and thus can affect the interpretation of measured data. Misinterpretation of measured data can lead to a false indication of a potential threat of discharge, i.e. lightning, thus unnecessarily causing economic losses for example in the operation of airports.

### Summary of the invention

The invention, according to the proposed solution, constitutes a method of monitoring of increased risk of lightning on the basis of information about the increase of electric charge of water droplets, which is obtained by measuring the characteristics of the scattered electromagnetic (EM) radiation. A change of these characteristics is related to the electric charge, which the droplets acquire, and not with the deformation of droplets, thereby solving to a great extent the drawbacks of the prior art solutions. In order to normalize the optical characteristics as well as the concentration of droplets, it is necessary that measurements are carried out at two suitably selected wavelengths. The suitable wavelengths can be arbitrarily combined, which explicitly includes the possibility of using two or more wavelengths.
The method of lightning threat indication is based on the fact that the information about the electric charge of water droplets is obtained by measuring the signal of backscattering of the electromagnetic radiation at two wavelengths. The operational range of wavelengths is from 1 to 50 mm; whereas, the dimension of monitored atmospheric particles is by at least two orders of magnitude smaller. Thresholds are set on the apparatus for lightning threat indication, then the two signals measured at two different wavelengths are monitored and compared. If the ratio of the two signals remains constant, it is a situation without risk of lightning threat. If the ratio of these two signals is increased by at least 10%, the situation is assessed as a risk in terms of lightning threat.

The threshold of the apparatus for lightning threat indication is set so that two arbitrary wavelengths are selected from the range 1 mm to 50 mm, and complex refractive indices of the droplets at both wavelengths are assessed from the tables. Subsequently, the theoretical difference between the signal without electric charge and the signal with electric charge is calculated. If the difference (N) is less than 10%, other wavelengths must be selected. If the difference N is greater than 10%, the selected wavelengths are applicable for the apparatus and the presence of electrically charged droplets will be indicated by a signal difference at the level of at least 0.75N.

The suitable wavelengths can be arbitrarily combined, which implicitly includes the possibility of using two or more wavelengths.

The apparatus, which indicates the lightning threat according to this invention, consists of a transmitter, a receiver, a control unit, a computer system and a data storage unit. In the computer system is bidirectionally connected to the control unit and to the data storage unit, within which, data are processed and calculations are performed, wherein the output information from the computer system is the generation and sending of a signal with warning of lightning risk.

The transmitter transmits at two or more different wavelengths. The electromagnetic wave is transmitted toward the cloud in which scattering by individual droplets takes place. The scattered waves propagate in all directions and the waves that travel back to the transmitter are detected by the receiver, which is located close to the transmitter. The components of the signal are separated using an electronic circuit or a computer program. After obtaining the signal intensity at both wavelengths, the ratio of these signals is evaluated by a computer system: if during monitoring of this ratio a change of the value of at least 0.75N is recorded, the change will be interpreted by the control unit as a threat risk of lightning and the control unit will automatically generate and send a signal with a warning of lightning risk.

With the increase of electric charge of water droplets in the atmosphere the probability of lightning occurrence also increases. As shown in [J. Klačka and M. Kocifaj, "Scattering of electromagnetic waves by charged spheres and some physical consequences," J. Quantitative Spectrosc. and Radiative Transfer 106, 170-183 (2007) and J. Klačka and Kocifaj M., "On the scattering of electromagnetic waves by a charged sphere," Progress In Electromagnetics Research, Vol. 109, 17-35 (2010)], the electric charge affects also the optical characteristics of light and other electromagnetic (EM) radiation.

Recently published theoretical work [J. Klačka and M. Kocifaj, "Scattering of electromagnetic waves by charged spheres and some physical consequences," J. Quantitative Spectrosc. and Radiative Transfer 106, 170-183 (2007)] has shown that the electric charge on droplets can affect the characteristics of the scattered EM signal. Changes of this signal are related to several parameters. First, significant changes in the properties of the signal can be expected only in the case of droplets that are much smaller than the wavelength of the incident radiation. Also, the material properties of droplets are very important. Droplets with properties close to dielectrics have a greater effect on the EM radiation than those having metallic properties.

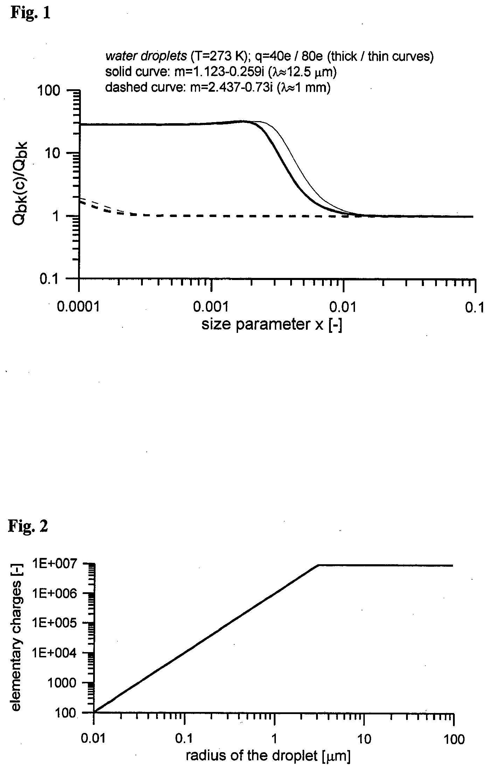

Figure 1 shows a plot of the ratio of the backscattering efficiency of a charged spherical droplet $Q_{bk}(c)$ to that of an uncharged droplet $Q_{bk}$ as a function of size parameter $x = 2\pi a/\lambda$, where $a$ is the radius of the water droplet and $\lambda$ is the wavelength of incident light. Curves are shown for two different wavelengths of EM radiation, at which the water droplets have different refractive indices. Different values of charge are also considered. What is evident from these curves is that the scattered EM signal is predominantly affected by the electric charge. In the case of large droplets, the ratio of backscatter efficiencies is equal to one; thus, it is identical to the asymptotic course, when we observe no effect of the charge on the scattering. However, it is obvious that the values of parameter $x$, for which a dependence of backscattering on electric charge can be observed, are affected by the amount of electric charge. The region in which the effect of electric charge becomes apparent is called the transition region. For solid curves in Figure 1, this transition region is observed in the range of $x \sim 0.002$ to $0.01$.

To highlight the changes during backscattering we have used a thick and a thin curve. The position of the transition region depends on the complex refractive index of the droplets and also on the wavelength of the incident radiation. In the case of a smaller refractive index and dielectric properties of the droplets, the transition region shifts towards larger values of the parameter $x$.

According to Pruppacher and Klett [H. R. Pruppacher, J. D. Klett, Microphysics of Clouds and Precipitation, Kluwer Academic Publishers, ISBN 0-7923-4409-X, pp. 930], the amount of elementary charge that can be placed onto a water droplet ranges from 1 to $10^8$, depending on the size of the droplet. The larger the droplet, the greater can be the charge. In calculations of the scattering from charged droplets, it is important to take this effect into consideration. Figure 2 shows a plot of the charge as a function of droplet radius. In the case of (lightning) discharges, we can expect similar amounts of charge.

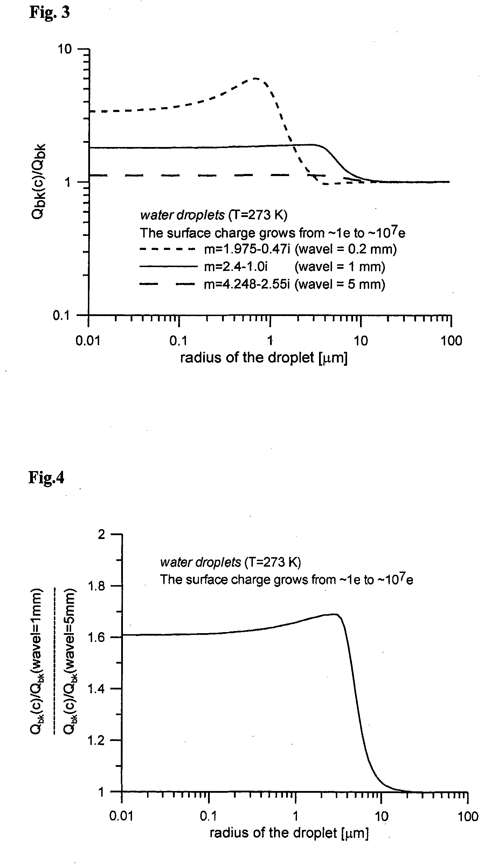

In Figure 3, the calculations of backscattering efficiency are presented, wherein the course of values of electric charge according to Figure 2 has been taken into account. The radius of the particles varied in the range from 0.01 to 100 micrometers and the calculations were performed for three wavelengths. We have chosen these three discrete wavelengths so that the refractive index of the droplets increases with the increasing wavelength. At the smallest wavelength, the particles have rather dielectric properties, and we observe the largest changes in the backscattering efficiency of small charged droplets. At the largest wavelength, these changes are the smallest, and the particles have metallic properties.

We designate $A(a; \lambda_1 : \lambda_2)$ to be the ratio of backscattering efficiencies of charged and uncharged droplets at two wavelengths:

$$A(a; \lambda_1 : \lambda_2) = \frac{\dfrac{Q_{bk}(c)(\lambda_1)}{Q_{bk}(\lambda_1)}}{\dfrac{Q_{bk}(c)(\lambda_2)}{Q_{bk}(\lambda_2)}} \ .$$

the variable $a$ in the above mentioned relation is the droplet radius. When analyzing the ratio $A(a; \lambda_1 : \lambda_2)$ as a function of droplet radius, we can find the transition region that separates the first part dependent on electric charge with values of $A>1$ from the second part with values of $A$ nearly indistinguishable from one. We are interested in the first region and the ratio mentioned above is designated as $A(\lambda_1 : \lambda_2)$.

$$A(\lambda_1 : \lambda_2) \ A(a < 5\mu m; \lambda_1 : \lambda_2)$$

The backscattering intensity measured by the detector is a superposition of the intensities of the scattered radiation generated by all droplets visible within the field of view of the apparatus.

In a first-order approximation of the scattering, the intensity of detected radiation for each of the above mentioned wavelengths is determined by the single scattering from the droplets, thus, for instance, the total intensity is

$$I(\lambda) = \sum_i I_i(\lambda) \ ,$$

where $I_i$ is the intensity of backscattered light from the $i$-th droplet. Because the droplets are much smaller than the wavelength, the scattering by uncharged droplets can be described using the Rayleigh scattering approximation:

$$I_i^{uncharged} = I_0 \frac{x_i^4 a_i^2}{r_i^2} \left| \frac{m_i^2 - 1}{m_i^2 + 2} \right|^2 = Q_{bk,i} I_0 \frac{a_i^2}{4 r_i^2} \ ,$$

where $I_0$ is the intensity of the incident radiation, and for the $i$-th droplet we define: $x_i$ as the size parameter, $a_i$ as the droplet radius, $m_i$ as the complex refractive index, $r_i$ as the distance from the detector and $Q_{bk,i}$ as the backscattering efficiency. The size parameter is defined as $x_i = 2\pi a_i / \lambda$, where $\lambda$ is the wavelength of incident radiation.

By measuring the backscattering intensities at two wavelengths we can calculate the value of the ratio

$$R(\lambda_1 : \lambda_2) = \frac{I_0(\lambda_1) \sum_i Q_{bk,i} \dfrac{a_i^2}{r_i^2}}{I_0(\lambda_2) \sum_i Q_{bk,i} \dfrac{a_i^2}{r_i^2}} = \frac{I_0(\lambda_1) \sum_i \dfrac{a_i^6}{r_i^2 \lambda_1^2} \left| \dfrac{m_i^2(\lambda_1) - 1}{m_i^2(\lambda_1) + 2} \right|^2}{I_0(\lambda_2) \sum_i \dfrac{a_i^6}{r_i^2 \lambda_2^2} \left| \dfrac{m_i^2(\lambda_2) - 1}{m_i^2(\lambda_2) + 2} \right|^2} \ ,$$

which is a constant independent of number and size of droplets, as these are much smaller than the wavelength. When the droplets are charged, this ratio will be

$$R(c)(\lambda_1 : \lambda_2) = \frac{I_0(\lambda_1) \sum_i Q_{bk,i}(c)(\lambda_1) \frac{a_i^2}{r_i^2}}{I_0(\lambda_2) \sum_i Q_{bk,i}(c)(\lambda_2) \frac{a_i^2}{r_i^2}}$$

When considering cloud particles, whose radii correspond to the first region with $A > 1$, we can select such wavelengths, for which there is little or no dependence on $Q_{bk}(c)/Q_{bk}$; i.e.,

$$c(\lambda_n) = \frac{Q_{bk,i}(c)(\lambda_n)}{Q_{bk,i}(\lambda_n)},$$

and so we obtain

$$\frac{R(c)(\lambda_1 : \lambda_2)}{R(\lambda_1 : \lambda_2)} = \frac{c(\lambda_1)}{c(\lambda_2)} = A(\lambda_1 : \lambda_2).$$

This result has the following meaning: by measuring the backscatter signals of EM radiation at the two wavelengths, it is found that the ratio of these two signals remains constant in the case of a conventional aqueous cloud, regardless of size or number of droplets. However, from the moment at which the charging of droplets starts to occur to the moment at which there is a potential threat of lightning, the ratio of signals of scattered radiation will increase proportionally to the factor $A(\lambda_1 : \lambda_2)$.

## Brief description of the drawings

Figure 1: Ratio of backscattering efficiencies of charged and neutral droplets as a function of size parameter $x$.

Figure 2: Plot of electric charge as a function of droplet radius based on the work of Pruppacher a Klett [3].

Figure 3: Ratio of the backscattering efficiencies of charged and uncharged droplets as a function of their radius.

Figure 4: $A(a; 1mm : 5mm)$ as a function of droplet radius.

Figure 5: Possible configuration of the apparatus: a simple configuration of the apparatus with a transmitter and a receiver placed at the same location.

Figure 6: Example of realization of the apparatus for two frequencies ($f_1$ and $f_2$).

Figure 7: Example of realization for a microwave generator, in which the switching between the operational frequencies $f_1$ and $f_2$ is controlled by a controller.

Figure 8: Example of realization for a solution with a circulator.

## Detailed description of the invention

The technology described in the summary of the invention is realized in practice by means of an apparatus that measures the intensity of backscattering at the two wavelengths. Figure 4 depicts the calculated ratio $A(1mm : 5mm)$, for instance, as a function of droplet radius for the case where $\lambda_1$ = 1mm and $\lambda_2$ = 5mm. This ratio is of about 1.6 for particles with radius lower than cca 5 $\mu$m. The transition region can be observed for particles with radii of 5 - 10 $\mu$m. For larger particles, the value of the function A asymptotically approaches 1. In the first region with droplet radii of less

than ~ 5 $\mu$m, the increase of the signals ratio is of approximately 60%.

Example 1:

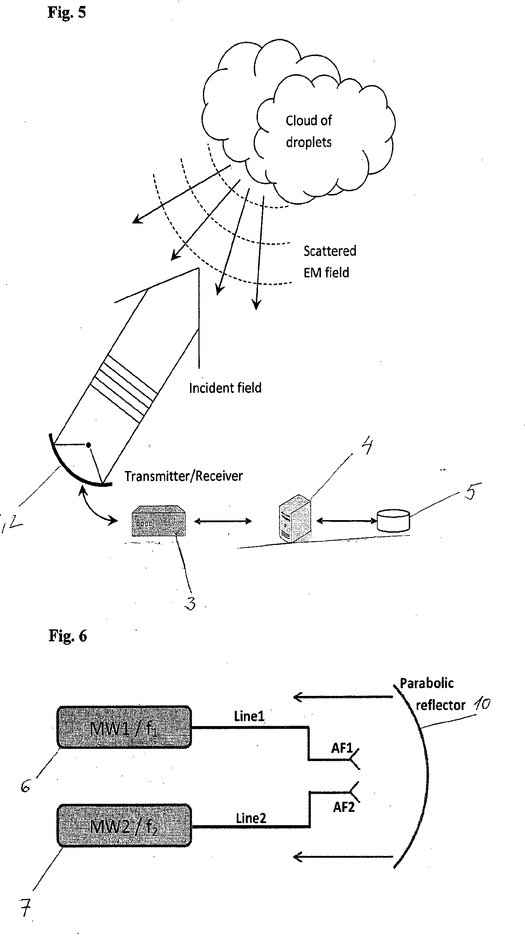

A simple configuration of the apparatus with a transmitter 1 and a receiver 2 located at the same location is depicted in Figure 5. The transmitter 1 generates EM radiation of two frequencies (or wavelengths) and the generated radiation is directed to the cloud of water droplets. The device can be constructed as radar, in which the source of EM radiation is directed to the clouds. In a traditional configuration, the transmitter 1 and the receiver 2 are simple devices, shaped as a parabola, or they can be separate devices. The wave will be transmitted towards the cloud, in which scattering on individual droplets occurs. Scattered waves propagate in all directions. Those that travel back toward the transmitter 1 are designated as backscattering waves and can be detected by the receiver 2 which is located close to, or collocated with, transmitter 1. The detected signal is a superposition of components of scattered radiation of both wavelengths.
A part of the radiation that is scattered on the droplets travels back and is registered by the receiver 2. The individual components of the intensities for the two wavelengths are recognizable by the computer system 4. The ratio of these intensities is monitored by the control unit 3. The data are stored in the data storage unit 5.

Example 2:

The second option is to use several detectors, each of which is tuned so that it collects only a signal of a specific frequency.
Figure 6 depicts an example of realization for two frequencies ($f_1$ and $f_2$), where two generators, microwave generator (1) 6 and microwave generator (2) 7, generate microwave radiation with $\lambda_1$ = 1mm and $\lambda_2$ = 5mm. The signals are sent to irradiator (1) 8 and irradiator (2) 9 and the radiation is then emitted to the atmosphere by means of parabolic reflector 10.

Example 3:

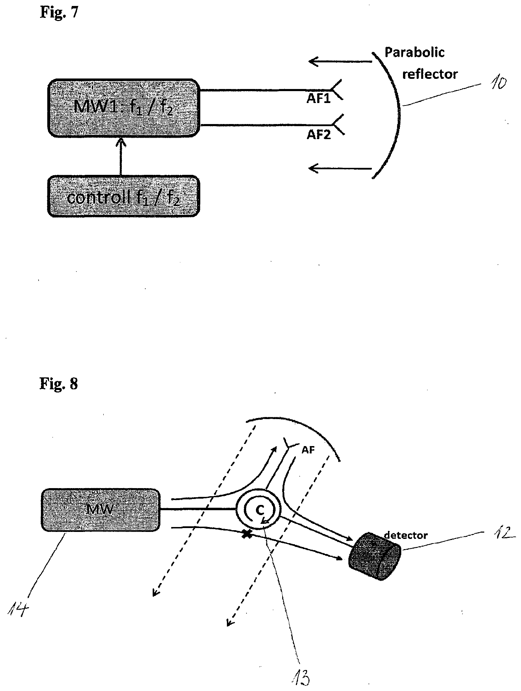

Another approach should be adopted in the case when the transmitter works in a pulse mode. Then it is convenient to generate and receive a signal of only one frequency, and subsequently to switch the device to another frequency mode, and after which the whole process is repeated cyclically. The receiver will process a rectangular signal, wherein the frequency will correspond to the frequency of the transmitter. Regardless of how the signal intensities at both wavelengths will be obtained, the ratio of these signals is given by the ratio of both components. If during the monitoring of the ratio $A(\lambda_1 : \lambda_2)$, a significant change is registered, this change will be interpreted as a result of electric charge in the clouds, and therefore also as a potential risk of lightning. Figure 7 depicts the realization for microwave generator 14, in which the switching between operational frequencies $f_1$ and $f_2$ is controlled by controller 11.

Example 4:

Figure 8 shows a solution with circulator 13, which releases a signal only in a certain direction, and so enables it to lead the signal to the irradiator 8 (AF1) and also to lead the detected signal from the atmosphere to the detector 12. The transition from the MW source - generator 14 to the detector 12 is not possible.

**Industrial applicability**

Lightning is particularly dangerous during landing and take-off of an aircraft, where it can cause loss of power or a complete failure of aircraft equipment resulting in catastrophe. To avoid this, airports close during increased lightning threats. However, the disablement of airports is extremely costly and therefore it is economically advantageous for airports to have a device for accurate indication of occurrence of dangerous lightning.

**Figure legend**

1 transmitter
2 receiver
3 control unit
4 computer system

5 data storage unit
6 generator 1
7 generator 2
8 irradiator 1
9 irradiator 2
10 parabolic reflector
11 controller
12 detector
13 circulator
14 microwave generator

## Claims

1.  Method of lightning threat indication, wherein information about an electric charge of water droplets is obtained by measuring a signal of backscattering of electromagnetic radiation, thresholds are set on an apparatus for lightning threat indication, then two signals are monitored and compared, wherein if a ratio of the two signals remains constant it is a situation without a risk of lightning threat, and if the ratio of these two signals increases above a threshold the situation is assessed as a risk of lightning threat, **characterized in that** the information about the electric charge of the droplets is obtained by measuring the signal of backscattering of electromagnetic radiation at two wavelengths resulting in two signals, which are the backscattering efficiencies of charged and uncharged particles in the form of droplets, derived from the backscattering intensities at the two wavelengths, wherein an operational range of wavelengths is from 1 to 50 mm, the dimension of the monitored particles is by at least two orders of magnitude smaller, then the two signals are monitored and compared at two different wavelengths, wherein if the ratio of these two signals increases by at least 10 % the situation is assessed as a risk of lightning threat.

2.  Method of lightning threat indication according to claim 1, **characterized in that** the threshold of the apparatus for lightning threat indication is set so that two arbitrary wavelengths are selected from the range 1 mm to 50 mm, complex refractive indices of the droplets at both wavelengths are assessed from tables, subsequently, the theoretical difference of the signal without electric charge and the signal with electric charge is calculated, and if the difference N alters by less than 10%, then other wavelengths must be selected, if the change in the difference N is greater than 10%, the selected wavelengths are applicable for the given apparatus and the presence of electrically charged droplets will be indicated by the signal difference at the level of at least 0.75N.

3.  Method of lightning threat indication according to claims 1 and 2, **characterized in that** the selected wavelengths are combined, allowing the use of two or more wavelengths.

4.  Apparatus for lightning threat indication, the apparatus comprising a transmitter (1), a receiver (2), a control unit (3), a computer system (4) and a data storage unit (5), the computer system (4) being bidirectionally connected to the control unit (3) and to the data storage unit (5), **characterized in that** the computer system is configured to process data and to perform calculations according to the method of one of the claims 1 to 3, wherein the output information from the control unit (3) is the generation and sending of a signal warning of lightning risk.

5.  Apparatus for lightning threat indication according to claim 4, **characterized by** further comprising several receivers (2), each of which is tuned so that it collects only a signal of a specific frequency.

6.  Apparatus for lightning threat indication according to claim 4 or 5, **characterized in that** the apparatus comprises a microwave generator (14), which operates in pulse mode, wherein a signal of only one frequency is generated and received, the microwave generator (14) being configured to then be switched to the second frequency mode, and this process is cyclically repeated.

7.  Apparatus for lightning threat indication according to one of the claims 4 to 6, **characterized in that** the apparatus comprises a circulator (13), configured to be used between the microwave generator (14) and the detector (12), and configured to release a signal only in a certain direction, wherein a transition from the microwave generator (14) to the detector (12) is not possible.

**Patentansprüche**

1. Verfahren zur Blitzschlaggefahranzeige, wobei Informationen über eine elektrische Ladung von Wassertröpfchen durch Messen eines Signals von Rückstreuung elektromagnetischer Strahlung erhalten werden und Schwellenwerte auf einer Vorrichtung zur Blitzschlaggefahranzeige gesetzt werden, dann zwei Signale überwacht und verglichen werden, wobei eine Situation ohne ein Risiko von Blitzschlaggefahr besteht, wenn ein Verhältnis der beiden Signale konstant bleibt und die Situation als ein Risiko für Blitzschlaggefahr beurteilt wird, wenn das Verhältnis der beiden Signale über einen Schwellenwert steigt,
dadurch gekennzeichnet, dass die Informationen über die elektrische Ladung der Tröpfchen durch Messen des Signals der Rückstreuung von elektromagnetischer Strahlung bei zwei Wellenlängen erhalten werden, wodurch sich zwei Signale ergeben, die die Wirkungsgrade der Rückstreuung von geladenen und ungeladenen Partikeln in Form von Tröpfchen sind, die von den Rückstreuungsintensitäten bei den beiden Wellenlängen abgeleitet sind, wobei ein Betriebsbereich von Wellenlängen von 1 bis 50 mm reicht und die Ausdehnung der überwachten Partikel mindestens zwei Größenordnungen kleiner ist, dann die beiden Signale überwacht und bei zwei verschiedenen Wellenlängen verglichen werden, wobei die Situation als ein Risiko für Blitzschlaggefahr beurteilt wird, wenn das Verhältnis der beiden Signale um mindestens 10 % steigt.

2. Verfahren zur Blitzschlaggefahranzeige nach Anspruch 1, dadurch gekennzeichnet, dass der Schwellenwert der Vorrichtung zur Blitzschlaggefahranzeige so eingestellt ist, dass zwei beliebige Wellenlängen aus dem Bereich von 1 mm bis 50 mm gewählt werden, komplexe Brechungsindizes der Tröpfchen bei beiden Wellenlängen aus Tabellen beurteilt werden, anschließend die theoretische Differenz des Signals ohne elektrische Ladung und des Signals mit elektrischer Ladung berechnet wird und dann, wenn die Differenz N sich um weniger als 10 % ändert, andere Wellenlängen gewählt werden müssen, und dann, wenn die Änderung der Differenz N größer als 10 % ist, die gewählten Wellenlängen für die gegebene Vorrichtung anwendbar sind und die Anwesenheit elektrisch geladener Tröpfchen durch die Signaldifferenz in Höhe von mindestens 0,75 x N angezeigt wird.

3. Verfahren zur Blitzschlaggefahranzeige nach den Ansprüchen 1 und 2, dadurch gekennzeichnet, dass die gewählten Wellenlängen kombiniert werden, wodurch die Verwendung von zwei oder mehr Wellenlängen möglich wird.

4. Vorrichtung zur Blitzschlaggefahranzeige, wobei die Vorrichtung Folgendes umfasst: einen Sender (1), einen Empfänger (2), eine Steuereinheit (3), ein Computersystem (4) und eine Datenspeichereinheit (5), wobei das Computersystem (4) bidirektional mit der Steuereinheit (3) und der Datenspeichereinheit (5) verbunden ist,
dadurch gekennzeichnet, dass das Computersystem konfiguriert ist, Daten zu verarbeiten und Berechnungen nach dem Verfahren eines der Ansprüche 1 bis 3 durchzuführen, wobei die Ausgangsinformationen der Steuereinheit (3) die Erzeugung und das Senden eines Warnsignals für ein Blitzschlagrisiko sind.

5. Vorrichtung zur Blitzschlaggefahranzeige nach Anspruch 4, dadurch gekennzeichnet, dass sie ferner mehrere Empfänger (2) umfasst, von denen jeder so abgestimmt ist, dass er nur ein Signal einer bestimmten Frequenz sammelt.

6. Vorrichtung zur Blitzschlaggefahranzeige nach Anspruch 4 oder 5, dadurch gekennzeichnet, dass die Vorrichtung einen Mikrowellengenerator (14) umfasst, der im Pulsmodus arbeitet, wobei ein Signal von nur einer Frequenz erzeugt und empfangen wird und der Mikrowellengenerator (14) konfiguriert ist, dann auf den zweiten Frequenzmodus umgeschaltet zu werden, und dieser Prozess zyklisch wiederholt wird.

7. Vorrichtung zur Blitzschlaggefahranzeige nach einem der Ansprüche 4 bis 6, dadurch gekennzeichnet, dass die Vorrichtung einen Zirkulator (13) umfasst, der konfiguriert ist, zwischen dem Mikrowellengenerator (14) und dem Detektor (12) verwendet zu werden, und konfiguriert ist, ein Signal nur in einer bestimmten Richtung abzugeben, wobei ein Übergang vom Mikrowellengenerator (14) zum Detektor (12) nicht möglich ist.

**Revendications**

1. Méthode d'indication de menace de foudre, dans laquelle des informations concernant une charge électrique de gouttelettes d'eau sont obtenues en mesurant un signal de rétrodiffusion de rayonnement électromagnétique, des seuils sont établis sur un appareil d'indication de menace de foudre, ensuite deux signaux sont surveillés et comparés, dans laquelle si un rapport de ces deux signaux reste constant, c'est une situation sans risque de menace de foudre, et si le rapport de ces deux signaux augmente au-dessus d'un seuil, la situation est évaluée comme étant un risque de menace de foudre, **caractérisée en ce que** les informations concernant la charge électrique des gouttelettes sont obtenues en mesurant le signal de rétrodiffusion de rayonnement électromagnétique à deux longueurs d'onde ayant pour résultat deux signaux, qui sont les efficacités de rétrodiffusion de particules chargées et non chargées sous la forme de gouttelettes, dérivées des intensités de rétrodiffusion aux deux longueurs d'onde, dans laquelle une plage opérationnelle de longueurs d'onde est de 1 à 50 mm, la dimension des particules surveillées est plus petite d'au moins deux ordres de grandeur, ensuite les deux signaux sont surveillés et comparés à deux longueurs d'onde différentes, si le rapport de ces deux signaux augmente d'au moins 10 %, la situation est évaluée comme étant un risque de menace de foudre.

2. Méthode d'indication de menace de foudre selon la revendication 1, **caractérisée en ce que** le seuil de l'appareil d'indication de menace de foudre est établi de sorte que deux longueurs d'onde arbitraires sont choisies dans la plage de 1 mm à 50 mm, des indices de réfraction complexes des gouttelettes aux deux longueurs d'onde sont évalués par rapport à des tables, par la suite, la différence théorique entre le signal sans charge électrique et le signal avec charge électrique est calculée, et si la différence N varie de moins de 10 %, alors d'autres longueurs d'onde doivent être sélectionnées, si la variation de la différence N est supérieure à 10 %, les longueurs d'onde sélectionnées sont applicables pour l'appareil donné et la présence de gouttelettes électriquement chargées sera indiquée par la différence de signal au niveau d'au moins 0,75N.

3. Méthode d'indication de menace de foudre selon les revendications 1 et 2, **caractérisée en ce que** les longueurs d'onde sélectionnées sont combinées, permettant l'utilisation de deux ou plus de deux longueurs d'onde.

4. Appareil d'indication de menace de foudre, l'appareil comprenant un émetteur (1), un récepteur (2), une unité de commande (3), un système informatique (4) et une unité de stockage de données (5), le système informatique (4) étant connecté de manière bidirectionnelle à l'unité de commande (3) et à l'unité de stockage de données (5), **caractérisé en ce que** le système informatique est configuré pour traiter des données et effectuer des calculs conformément à la méthode selon l'une des revendications 1 à 3, dans lequel les informations de sortie de l'unité de commande (3) sont la génération et l'envoi d'un signal avertissement d'un risque de foudre.

5. Appareil d'indication de menace de foudre selon la revendication 4, **caractérisé en ce qu'**il comprend en outre plusieurs récepteurs (2), chacun d'entre eux étant réglé de sorte qu'il ne recueille uniquement qu'un signal d'une fréquence spécifique.

6. Appareil d'indication de menace de foudre selon la revendication 4 ou 5, **caractérisé en ce que** l'appareil comprend un générateur de micro-ondes (14), qui fonctionne en mode pulsé, dans lequel un signal d'une seule fréquence est généré et reçu, le générateur de micro-ondes (14) étant configuré pour être ensuite commuté dans le second mode de fréquence, et ce processus est répété cycliquement.

7. Appareil d'indication de menace de foudre selon l'une des revendications 4 à 6, **caractérisé en ce que** l'appareil comprend un circulateur (13), configuré pour être utilisé entre le générateur de micro-ondes (14) et le détecteur (12), et configuré pour libérer un signal uniquement dans une certaine direction, dans lequel une transition du générateur de micro-ondes (14) au détecteur (12) n'est pas possible.

## Fig. 1

*water droplets* (T=273 K); q=40e / 80e (thick / thin curves)
solid curve: m=1.123-0.259i ($\lambda\approx$12.5 μm)
dashed curve: m=2.437-0.73i ($\lambda\approx$1 mm)

## Fig. 2

**Fig. 3**

water droplets (T=273 K)
The surface charge grows from ~1e to ~10⁷e

**Fig.4**

water droplets (T=273 K)
The surface charge grows from ~1e to ~10⁷e

**Fig. 5**

Cloud of droplets

Scattered EM field

Incident field

Transmitter/Receiver

**Fig. 6**

Parabolic reflector $10$

Line1

Line2

MW1 / $f_1$

MW2 / $f_2$

AF1

AF2

Fig. 7

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4792806 A
- US 5140523 A
- US 5621410 A
- US 6405134 B
- US 6586920 B
- US 6828911 B
- US 7069258 B
- US 2011090111 A1
- JP H09329672 A
- EP 0186402 A2

**Non-patent literature cited in the description**

- **J. KLAČKA ; M. KOCIFAJ.** Scattering of electromagnetic waves by charged spheres and some physical consequences. *J. Quantitative Spectrosc. and Radiative Transfer,* 2007, vol. 106, 170-183
- **J. KLAČKA ; KOCIFAJ M.** On the scattering of electromagnetic waves by a charged sphere. *Progress In Electromagnetics Research,* 2010, vol. 109, 17-35
- **H. R. PRUPPACHER ; J. D. KLETT.** Microphysics of Clouds and Precipitation. Kluwer Academic Publishers, 930